# EUROPEAN PATENT SPECIFICATION

(11) **EP 0 283 219 B1**
(45) Date of publication and mention of the grant of the patent: **07.07.1993**
(21) Application number: 88302142.0
(22) Date of filing: 11.03.1988
(51) Int. Cl.: G01R 1/073, G01R 31/28

(54) **Apparatus for automatically scrubbing a surface**
Gerät zum automatischen Reinigen einer Oberfläche
Appareil pour frotter automatiquement une surface

(30) Priority: 11.03.1987 US 24743
(43) Date of publication of application: 21.09.1988
(60) Divisional application: 89203096.6
(73) Proprietor: Hewlett-Packard Company, Palo Alto, California 94304 (US)
(72) Inventor: Huff, Richard E., Belmont, CA 94002 (US); Perlaki, Miklos K., Rocklin, CA (US)
(74) Representative: Williams, John Francis

(56) References cited:
- DE-B- 2 613 858
- US-A- 3 702 439
- US-A- 4 103 232
- IBM TECHNICAL DISCLOSURE BULLETIN, vol. 16, no. 12, May 1974, pages 4087-4088, New York, US; C.T. McNUTT: "Test carrier for "leadless" hybrid diode matrix modules"

## Description

The invention relates to the field of automatic surface scrubbers.

In order to conduct tests on the electronic components of a wafer, a test probe must form a low impedance connection with the wafer. Often, silicon wafers have contact pads coated with aluminum. This aluminum coating readily oxidizes into a non-conductive film 5 - 10 nm thick. When a test probe contacts this surface, the oxide film insulates the wafer from the test probe. In order to make a low impedance connection, the test probe must scrub the wafer's contact pads.

Wafer test probes commonly have numerous wires that dig into contact pads of the wafer under test. The digging ploughs oxide off the contact pads and permits a low impedance connection. If a test probe uses contact pads instead of wires, as described in EP 0230348 entitled Test Probe, published 29.07.87, the oxide remains on the wafer's contact pads and prevents the test probe from making a low impedance connection with the wafer. In order to perform the high frequency testing that modern day wafers require, the test probe must form a low impedance connection with the wafer. If the test probe cannot make a low impedance connection with the wafer, the high frequency tests must be delayed until the wafer is diced and packaged as chips. At this point, the loss is greater if a packaged chip must be discarded since the investment is greater.

A testing machine for wafers is disclosed in US-A-4103 232, but in this the contact probes are merely applied with a predetermined pressure against the pads. Something further is needed to reduce impedance, and the idea of a slight sideways movement (called scrubbing) is known for this - see, for example, DE-B-2613858. This motion breaks the oxide layer covering the wafer contact pads and exposes the fresh underlying metal. With the exposure to the fresh underlying metal the test probe makes a low impedance connection with the wafer under test.

According to the present invention there is provided an apparatus according to claim 1.

The constant length pivot device is a leaf spring or a device equivalent to a leaf spring. The variable length spring has a leaf spring or a device equivalent to a leaf spring and expansion device that lengthens in the sideways direction. The expansion device can be an integral part of the traveling device and can have holes that expand in the direction of motion.

The present invention has the advantage of producing a controlled scrub of a wafer or other device. By controlling the parameters of the constant length pivot device and the variable length spring, one controls the scrub motion. When the present invention is used to scrub the contact pads of wafers, it has the additional advantage that all contact pads receive the same scrub motion.

Figure 1 shows the preferred embodiment of the invention.

Figure 2 shows a top view of the apparatus shown in Figure 1.

Figure 3 shows a cross section A-A designated in Figure 2.

Figure 4 shows an alternate embodiment of the variable length spring.

The items have been given a two-part number with a dash separating the parts. The number to the left of the dash refers to the figure number and the number to the right of the dash refers to the part number. Part numbers will remain unchanged from drawing to drawing.

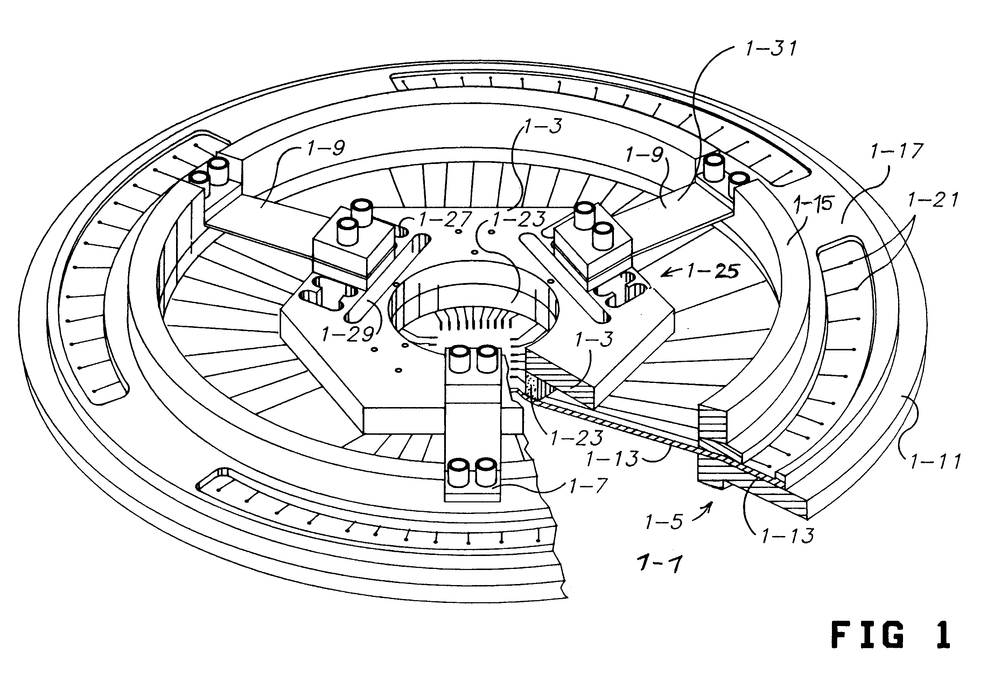

Figure 1 shows an apparatus according to the preferred embodiment of the invention. The cut away portion 1-1 shows a cross section of the apparatus. The travelling device 1-3 is connected to a base 1-5 through the constant length pivot device 1-7 and two variable length devices 1-9 located 120° apart. Alternate embodiments of the invention may use more than one constant length pivot device 1-7 and one or more variable length devices 1-9. In the preferred embodiment the invention, the base 1-5 has a base ring 1-15 attached to a base plate 1-11. As shown in the cut away, a membrane 1-13 is clamped between the base plate 1-11 and the base ring 1-15. In alternate embodiments of the invention, a mechanism which responds to pressure like the membrane probe described, viz., by moving sideways by about 20 microns to effect a scrubbing action on the test pads in contact, could be used instead of the membrane 1-13. In the preferred embodiment of the invention, the membrane 1-13 is a test probe membrane as discussed EP 0230348 mentioned above. A protective layer 1-17 resides between the base ring 1-15 and the base plate 1-11. This protective layer 1-17 protects the membrane 1-13 while exposing the test equipment contacts 1-21 which form interface ports receiving test signals for the probe.

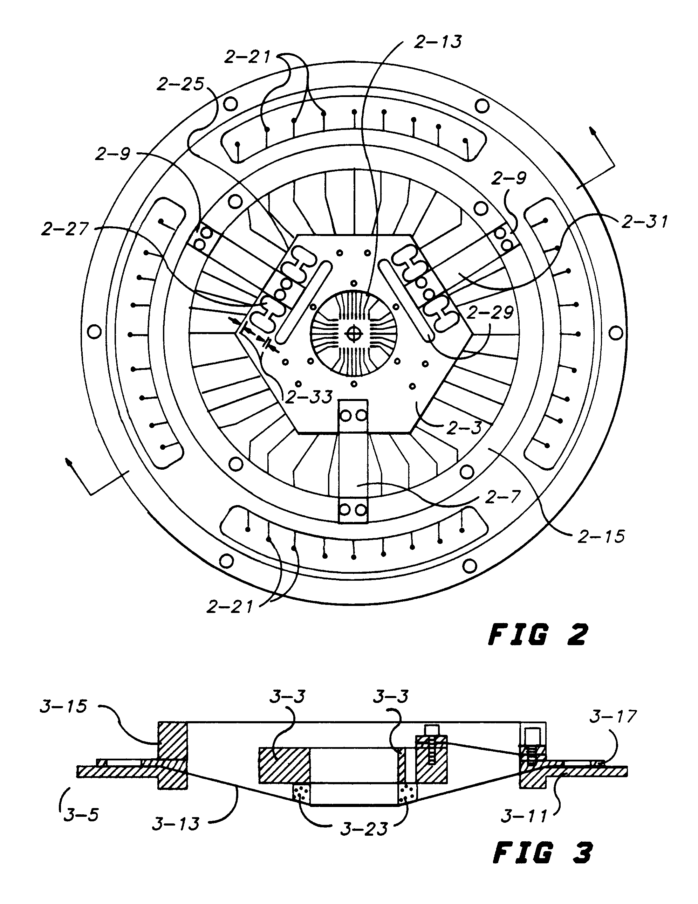

The membrane 1-13 engages with the travelling device 1-3 through an insulator 1-23. The insulator 1-23 is constructed from plastic such as 'lexan' (TM) and protects the delicate membrane 1-13 from abrading with the travelling means 1-3. More importantly, the insulator 1-23, 3-23 deflects the membrane 1-13, 3-13 away from the base 1-5, 3-5 as shown in Figure 3.

In the apparatus according to the preferred embodiment of the invention, the travelling device 1-3, 2-3 is a metal hexagonal plate, .31 cm thick. The travelling device 1-3, 2-3 has a large hole for visually aligning the membrane 1-13 with the wafer under test. In the preferred embodiment of the invention, the constant length spring device 1-7, 2-7 is a leaf spring connected between the travelling device 1-3 and the base ring 1-15. In alternate embodiments of the invention, the constant length pivot device 1-7 can have numerous embodiments such as rod, bar, or other stiff member connected between the travelling device 1-3 and the base ring 1-15 through pivot joints which allow the rod, bar, or other stiff member to rotate.

In the preferred embodiment of the invention, the variable length spring 1-9 has a expansion device 1-25 and a leaf spring 1-31 that is connected between the base ring 1-15 and the expansion device 1-25. The leaf spring 1-31 is very similar to the constant length pivotal device 1-7. Likewise, the leaf spring 1-31 can be replaced by a rod, bar, or other stiff member connected between base ring 1-15 and the expansion device 1-25 through a pivot joint. In the preferred embodiment of the invention, the expansion device 1-25 is an integral part of the traveling device 1-3. In alternate embodiments of the invention, the expansion device 1-25 may be a separate component. The expansion device 1-25 lengthens in the direction of the traveling device's 1-3 sideways motion. In the preferred embodiment, each variable length spring has one expansion device 1-25. Each expansion device 1-25 has two H-shaped holes 1-27 and one elongated hole 1-29. In operation, the constant length pivotal device 1-7 pulls the traveling device 1-3 towards itself. The H-shaped holes 1-27 are weak in this direction and expand under the pulling force. Additionally, the two elongated holes 1-29 are weak in the direction of the traveling device's 1-3 motion. When the H-shaped holes 1-27 and the elongate holes 1-29 expand in the direction of the constant length pivot device 1-7, the traveling device 1-3 and the attached membrane 1-14 move sideways.

The spring rate of the variable length spring 1-9 depends primarily on three major factors. The stiffness of the web which is determined by the web thickness 2-33; the distance across the two H-shaped holes 1-27; and the dimensions of the constant length spring 1-7. In the preferred embodiment of the invention, the web thickness is .38 cm throughout the variable length spring 1-9. And the constant length pivotal device has a length equal to .95 cm, width equal to .63 cm, and a thickness equal to .03 cm. The resulting variable length spring 1-9 has spring rate of 44650 kg/m (2500 lb/in). With a spring rate of 44650 kg/m (2500 lb/in), the constant length pivot device 1-7 must pull on the variable length spring device with a force of 8.8N (2 lb) to make the variable length spring device move sideways 20 microns. The H-shaped hole 1-27 reduces the spring rate and thereby reduces the force the constant length pivot device 1-7 must exert in order to produce a sideways motion of 20 microns. This has the advantage of reducing the force between the wafer and the test probe.

The apparatus, according to the preferred embodiment of the invention, is designed so that the traveling device 1-3 does not tilt. There are several features of the traveling device 1-3 and the expansion device 1-25 that prevent the tilting. The traveling device 1-25 is relatively thick so that it does not bend. Additionally, the H-shaped holes 1-27 and the elongated holes 1-29 are designed to be weak in the sideways direction of travel but strong in every other direction. The H-shaped holes 1-27 can be viewed as rectangular hole with metal extensions into the holes which make the traveling device, in the vicinity of the hole, resistent to bending or tilting. Alternate embodiments of the invention may have a expansion device with holes having a different shape without departing from the scope of the invention. Additionally, tilting of the travelling device 1-3 may be acceptable or even desirable in some applications. The resulting alternate embodiments may allow tilting without departing from the scope of the present invention. In other alternate embodiments, the expansion device 1-25 may have an accordian or other structure that expand when placed under tension. Such an embodiment does not depart from the scope of the present invention.

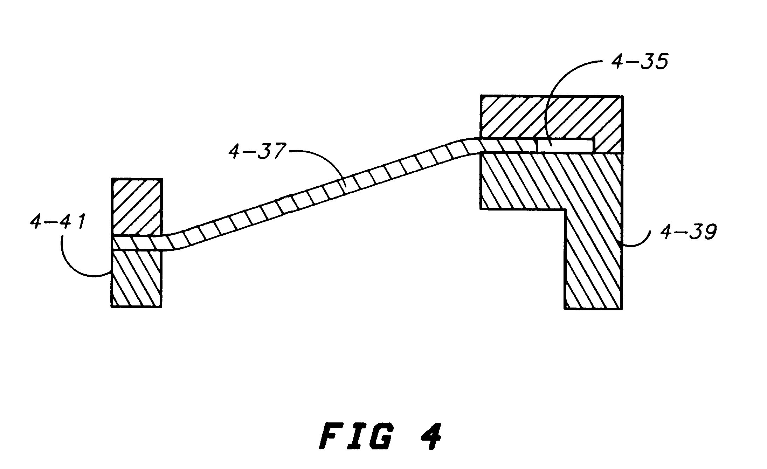

An alternate embodiment of the invention uses the variable length spring shown in Figure 4. A flexture pivot 4-37 moves out of the confinement slot 4-35 as the travelling device 4-39 is pushed away from the base 4-41. The confinement slot 4-35 confines the motion of the flexture pivot 4-37 to the horizontal plane and only allows the flexture pivot 4-37 to apply verticle forces to the travelling device 4-39. This embodiment has the advantage that no sideways forces or torques are applied to the travelling device 4-39 or the flexture pivot 4-37.

An apparatus according to the preferred embodiment of the invention is used as follows: The test wafer is pushed against the probe card at its contact area (1-13, 2-13). Specifically, the wafer is held on a chuck; it is then stepped and position directly under the probe card (1-3), which is held in a fixed position by a "prober" harness. Once the wafer is in position, that is aligned to the contacts on the probe card, the chuck is activated to push the wafer against the probe card contacts. As the probe card makes contact with the wafer, its contact pads are pushed and forced to move sideways by about 20 microns to slightly abrade the surface of the test wafer contact pads. This action results in clean metal on the contacts for making good electrical contact.

Pushing a wafer against the test probe membrane 1-13 causes the travelling means 1-3 to lift out of the resting position shown in Figure 1. When the wafer pushes the travelling device 1-3 out of its resting position, the constant length pivot device 1-7 rotates upwards and thereby exerts a force on the traveling device 1-3 which tends to pull it towards the constant length pivot device 1-7. The leaf springs 1-31 of the variable length spring device 1-9 also rotates upwards. In response to forces exerted by the constant length pivotal device 1-7, the expansion device 1-25 lengthens to allow the traveling device 1-3 and the attached membrane 1-13 to move sideways toward said constant length pivot device 1-7. The expansion device 1-25 lengthens by the expansion of the H-shaped hole 1-27 and the elongated hole 1-29 in the direction of the constant length pivot device 1-7.

The apparatus according to the preferred embodiment of the present invention is manufactured by drilling the elongated holes 1-29 and the H-shaped holes 1-27 into a plate of metal .31 cm thick. The drill has a diameter of .16 cm

Three leaf springs 1-7 and 1-31 of equal length are mounted between the base 1-5 and the traveling device 1-3. The leaf springs are located 120 degrees apart so that they will act symmetrically. Two leaf springs are located adjacent to the extension device 1-25. The membrane 1-13 is glued to an insulator ring 1-23 which is mounted on the traveling device 1-3. A solid spring is placed on top of the traveling device 1-3. In the preferred embodiment of the invention, an apparatus for aligning the membrane 1-13 with the wafer under test is attached to the apparatus 1-2.

## Claims

1. An apparatus, for scrubbing the contact pads of a semiconductor wafer, comprising: a base means (1-5); a travelling means (1-3); a variable length spring means (1-9) attached to said travelling means (1-3) and said base means (1-5); a constant length pivot means (1-7) attached to said travelling means (1-3) and said base means (1-5); and wherein the movement of said travelling means (1-3) vertically away from said base means (1-5) forces said constant length pivot means (1-7) to rotate about said base means (1-5), which forces said variable length spring means (1-9) to expand, characterised in that the respective constraints of the pivot means (1-7) and the spring means (1-9) on the travelling means (1-3) cause the latter to move also horizontally sideways as it moves vertically away from said base means (1-5).

2. An apparatus as claimed in claim 1 comprising: a test probe means (1-13) attached to said travelling means (1-3) mounted so that said test probe (1-13) scrubs said contact pads of said wafer when the travelling means (1-3) moves sideways.

3. An apparatus as in claim 1 or 2 wherein said variable length spring means (1-9) and said constant length pivot means (1-7) are attached to different halves of said travelling means (1-3).

4. An apparatus as in claim 1,2 or 3 wherein said constant length pivot means (1-7) is a leaf spring attached between said base means (1-5) and said travelling means (1-3).

5. An apparatus as in any preceding claim wherein said constant length pivot means (1-7) comprises: a first pivot attached to said travelling means a second pivot attached to said base means; and a rod attached to first pivot and said second pivot.

6. An apparatus as in any preceding claim wherein said variable length spring means (1-9) further comprises: a means for expanding (1-25) in said sideways direction a second constant length pivot means (1-31) attached to said means for expanding (1-25) in said sideways direction; and wherein said rotation of said constant length spring means (1-3) causes said means for expanding (1-25) to expand sideways which forces said travelling means (1-3) to move sideways.

7. An apparatus as in claim 6 wherein said means for expanding (1-25) is attached to said travelling means (1-3); and said second constant length pivot means (1-31) is a leaf spring attached to said means for expanding (1-25) and said base means (1-5).

8. An apparatus as in claim 6 or 7 wherein said means for expanding (1-24) in said sideways direction is in integral part of said travelling means (1-3).

9. An apparatus as in claim 6,7 or 8 wherein said means for expansion (1-25) comprises: an elongated hole (1-29) with the elongated axis perpendicular to the direction of said sideways motion; and two H-shaped holes (1-27) placed adjacent to said elongated hole (1-29).

10. An apparatus as in any preceding claim wherein said variable length spring means (1-9) further comprises: a flexure pivot (4-37) fastened to said base means (4-41); and a confinement slot (4-35) located on said travelling means (4-39) that permits said flexure pivot (4-37) to move in and out of said confinement slot (4-35).

## Patentansprüche

1. Einrichtung zum automatischen Reinigen der Kontaktflächen eines Halbleiter-Wafers, mit einer Sockelvorrichtung (1-5), einer Fahrvorrichtung (1-3), einer Federeinrichtung (1-9) variabler Länge, die an der Fahrvorrichtung (1-3) und der Sockelvorrichtung (1-5) befestigt ist, einer Schwenkvorrichtung (1-7) konstanter Länge, die an der Fahrvorrichtung (1-3) und der Sockelvorrichtung (1-5) befestigt ist, wobei die Bewegung der Fahrvorrichtung (1-3) vertikal weg von der Sockelvorrichtung (1-5) die Drehung der Schwenkvorrichtung (1-7) konstanter Länge um die Sockelvorrichtung (1-5) erzwingt, so daß sich die Federeinrichtung (1-9) variabler Länge ausdehnt, dadurch **gekennzeichnet,** daß die jeweils von der Schwenkvorrichtung (1-7) und der Federvorrichtung (1-9) auf die Fahrvorrichtung (1-3) ausgeübten Zwänge, daß sich die letztere dann, wenn sie sich vertikal von der Sockelvorrichtung (1-5) wegbewegt, auch horizontal zur Seite bewegt.

2. Einrichtung nach Anspruch 1, mit einer an der Fahrvorrichtung (1-3) befestigten Prüffühler-Vorrichtung (1-13), die so angebracht ist, daß der Prüffühler (1-13) die Kontaktflächen des Wafers schrubbt, wenn sich die Fahrvorrichtung (1-3) seitwärts bewegt.

3. Einrichtung nach Anspruch 1 oder 2, bei der die Federvorrichtung (1-9) variabler Länge und die Schwenkvorrichtung (1-7) konstanter Länge an verschiedenen Hälften der Fahrvorrichtung (1-3) angebracht sind.

4. Einrichtung nach Anspruch 1, 2 oder 3, bei der die Schwenkvorrichtung (1-7) konstanter Länge eine zwischen der Sockelvorrichtung (1-5) und der Fahrvorrichtung (1-3) befestigte Blattfeder ist.

5. Einrichtung nach einem der vorangehenden Ansprüche, bei der die Schwenkvorrichtung (1-7) konstanter Länge einen ersten an der Fahrvorrichtung befestigten Drehzapfen, einen zweiten an der Sockelvorrichtung befestigten Drehzapfen und einen am ersten Drehzapfen und am zweiten Drehzapfen befestigten Stab aufweist.

6. Einrichtung nach einem der vorangehenden Ansprüche, bei der die Federvorrichtung (1-9) variabler Länge eine Vorrichtung zum Ausdehnen (1-25) in seitlicher Richtung aufweist, wobei eine zweite Schwenkvorrichtung (1-31) konstanter Länge an dieser Vorrichtung zum Ausdehnen (1-25) in seitlicher Richtung befestigt ist, und wobei die Drehung der Federvorrichtung (1-9) konstanter Länge bewirkt, daß die Vorrichtung zum Ausdehnen (1-25) in seitlicher Richtung eine seitliche Bewegung der Fahrvorrichtung (1-3) erzwingt.

7. Einrichtung nach Anspruch 6, bei der die Ausdehnungsvorrichtung (1-25) an der Fahrvorrichtung (1-3) befestigt ist und die zweite Schwenkvorrichtung (1-31) konstanter Länge eine an der Ausdehnungsvorrichtung (1-25) und der Sockelvorrichtung (1-5) befestigte Blattfeder ist.

8. Einrichtung nach Anspruch 6 oder 7, bei der die Vorrichtung zum Ausdehnen (1-25) in seitliche Richtung ein integraler Bestandteil der Fahrvorrichtung (1-3) ist.

9. Einrichtung nach Anspruch 6, 7 oder 8, bei der die Ausdehnungsvorrichtung (1-25) ein Langloch (1-29), dessen verlängerte Achse senkrecht zur seitlichen Bewegungsrichtung verläuft, und zwei H-förmige Löcher (1-27) benachbart dem Langloch (1-29) aufweist.

10. Einrichtung nach einem der vorangehenden Ansprüche, bei der die Federvorrichtung (1-9) variabler Länge einen an der Sockelvorrichtung (4-41) befestigten Biegungs-Schwenkzapfen (4-37) und einen an der Fahrvorrichtung (4-39) vorgesehenen Begrenzungsschlitz (4-35) aufweist, der erlaubt, daß der Biegungs-Schwenkzapfen (4-37) sich in den und aus dem Begrenzungsschlitz (4-35) heraus bewegt.

## Revendications

1. Un appareil pour frotter les plots de contact d'une pastille semiconductrice, comprenant : un moyen formant base (1-5) ; un moyen de déplacement (1-3) ; un moyen formant ressort de longueur variable (1-9) fixé sur ledit moyen de déplacement (1-3) et sur ledit moyen de base (1-5) ; un moyen (1-7) formant pivot de longueur constante, fixé sur ledit moyen de déplacement (1-3) et sur ledit moyen de base (1-5) ; appareil dans lequel le mouvement dudit moyen de déplacement (1-3) verticalement en éloignement dudit moyen de base (1-5) oblige ledit moyen (1-7) formant pivot de longueur constante à tourner autour dudit moyen de base (1-5), ce qui produit une expansion dudit moyen (1-9) formant ressort de longueur variable, caractérisé en ce que les contraintes respectives exercées par le moyen formant pivot (1-7) et le moyen formant ressort (1-9) sur le moyen de déplacement (1-3) obligent ce dernier à se déplacer également horizontalement et latéralement à mesure qu'il s'éloigne verticalement dudit moyen de base (1-5).

2. Un appareil tel que revendiqué dans la revendication 1, comprenant : un moyen (1-13) formant sonde de test, fixé sur ledit moyen de déplacement (1-3) et monté de telle sorte que ladite sonde de test (1-13) exerce un frottement sur lesdits plots de contact de ladite pastille quand le moyen de déplacement (1-3) se déplace latéralement.

3. Un appareil tel que revendiqué dans la revendication 1 ou 2, dans lequel ledit moyen (1-9) formant ressort de longueur variable et ledit moyen (1-7) formant pivot de longueur constante sont fixés sur des moitiés différentes dudit moyen de déplacement (1-3).

4. Un appareil tel que revendiqué dans la revendication 1, 2 ou 3, dans lequel ledit moyen (1-7) formant pivot de longueur constante est une lame élastique fixée entre ledit moyen de base (1-5) et ledit moyen de déplacement (1-3).

5. Un appareil selon une quelconque des revendications précédentes, dans lequel ledit moyen (1-7) formant pivot de longueur constante comprend : un premier pivot fixé sur ledit moyen de déplacement, un second pivot fixé sur ledit moyen de base ; et une tige fixée sur ledit premier pivot et ledit second pivot.

6. Un appareil selon une quelconque des revendications précédentes, dans lequel ledit moyen (1-9) formant ressort de longueur variable comprend en outre : un moyen (1-25) pour l'expansion dans ladite direction latérale d'un second moyen (1-31) formant pivot de longueur constante qui est fixé sur ledit moyen (1-25) d'expansion dans ladite direction latérale ; et dans lequel ladite rotation dudit moyen (1-3) formant ressort de longueur constante fait en sorte que ledit moyen d'expansion (1-25) produise une expansion latérale qui oblige ledit moyen de déplacement (1-3) à se déplacer latéralement.

7. Un appareil selon la revendication 6, dans lequel ledit moyen d'expansion (1-25) est fixé sur ledit moyen de déplacement (1-3) ; et ledit second moyen (1-31) formant pivot de longueur constante est une lame élastique fixée sur ledit moyen d'expansion (1-25) et sur ledit moyen de base (1-5).

8. Un appareil selon une des revendications 6 ou 7, dans lequel ledit moyen d'expansion (1-25) dans ladite direction latérale fait partie intégrante dudit moyen de déplacement (1-3).

9. Un appareil selon une des revendications 6, 7 ou 8, dans lequel ledit moyen d'expansion (1-25) comprend : un trou allongé (1-29) dont l'axe longitudinal est orienté perpendiculairement à la direction dudit mouvement latéral ; et deux trous (1-27) en forme de H qui sont situés dans des positions adjacentes audit trou allongé (1-29).

10. Un appareil selon une quelconque des revendications précédentes, dans lequel ledit moyen (1-9) formant ressort de longueur variable comprend en outre : un pivot de flexion (4-37) fixé sur ledit moyen de base (4.41) ; et une fente de retenue e(4-35) située dans ledit moyen de déplacement (4-39) et qui permet audit pivot de flexion (4-37) de rentrer dans et de sortir de ladite fente de retenue (4-35).
